# EUROPEAN PATENT SPECIFICATION

(11) **EP 2 864 736 B1**
(45) Date of publication and mention of the grant of the patent: **17.08.2022**
(21) Application number: 13750390.0
(22) Date of filing: 20.06.2013
(51) Int. Cl.: G01D 4/00, H01H 71/12, H02H 1/00

(54) **CIRCUIT BRANCH MEASURING SYSTEM**
MESSSYSTEM FÜR EINE VERZWEIGUNGSSCHALTUNG
SYSTÈME DE MESURE DE BRANCHES DE CIRCUIT

(30) Priority: 20.06.2012 IS 9002; 04.07.2012 IS 9004
(43) Date of publication of application: 29.04.2015
(73) Proprietor: eTactica ehf., 105 Reykjavik (IS)
(72) Inventor: AXELSSON, Halldor, IS-220 Hafnarfjordur (IS); EINARSSON, Ragnar, IS-105 Reykjavik (IS); JONSSON, Bjarni Malmquist, IS-112 Reykjavik (IS); PALSSON, Karl, IS-101 Reykjavik (IS); JONSSON, Hilmir Ingi, IS-240 Grindavik (IS)
(74) Representative: Arnason Faktor
(86) International application number: PCT/IS2013/050006
(87) International publication number: WO 2014/009976

(56) References cited:
- EP-A1- 2 282 321
- WO-A1-2010/102150
- DE-A1-102006 059 384
- US-A1- 2008 284 614
- US-A1- 2010 207 604
- US-B2- 7 453 267

## Description

### Field of the invention

The present invention relates generally to power measurement systems, and more particularly to a circuit branch measuring system by a current measurement and data transmission device comprising sensor modules for detecting current in an electrical power system.

### Background of the invention

Measurement devices for measuring a current flowing through a conductor by a circuit breaker are known in the art to be auxiliary devices which are attached to circuit breakers for measuring distinct currents. In practice these devices generally include sensing means for detecting a current, a micro-processor for processing the signal from the sensing means, and output for transmitting the processed data signal from the microprocessor including an input for powering the microprocessor from an external source. An example of such a device is described in UK patent application GB 2,450,426 and in EP 2,282,321. Furthermore, circuit breakers comprising integrated current detectors are known in the art to comprise a microprocessor to process a current signal from the current detector and voltage signals to provide test signals and controlling functions. An example of such a device is described in US 7,177,129. Power systems such as circuit branch monitoring systems for measuring and collecting data from electrical distribution boards are known in the art to utilize up to numerous current detectors for measuring and collecting energy data. An example of such a system is described in US 7,453,267. US 7,546,214 discloses a system for making available information associated with power consumption from a circuit branch. The system includes an electrical panel board distributing power to circuits, circuit breakers in power connection with the conductors of the circuits, a voltage sensor and a hub to collect the information associated with power consumption from the voltage sensor and the circuit breaker. This system has a data collector to collect and make available to a user the information associated with power consumption. The problem with this system is the size and limited communication abilities.

The devices and systems use independent current sensor modules in a wired bus network for detecting a current value from a conductor by a circuit breaker. This is especially disadvantageous as distribution panels are typically dense with separate conductors related to each circuit breaker, neutral and ground connections of each circuit branch, including conductors for the Main breaker and other protection devices associated to an electrical installation. As circuit breakers by an installation in distribution cabinets are typically numerous and positioned in line and relatively close to one another this arrangement is also costly and impractical by installation. This is especially disadvantageous due to dimensional restrains in electrical distribution panels around circuit breakers and conductor connections thereto, as each the individual current sensor module is linked to each the circuit breaker by a separate conductor.

Power systems for monitoring circuit branches are known to power the current sensors directly from the current branch circuit line. This is disadvantageous as powering the current sensors from the circuit line may increase the power of the circuit line and thus affect the desired measurement.

Therefore there remains a need for an improved and simplified circuit branch measurement system to measure, collect and transmit energy data by electrical distribution panels. The present invention is provided to solve these matters and others.

US 2010/207604 discloses a device for measuring electric power consumed by a plurality of branch circuits comprising interchangeable current transformers with respective transformer memories for storage of transformer characterization data. The devices allow self-discovery of a phase shift induced by respective current transformers and the phase of current conducted by each branch circuit.

US 2008/284614 discloses a power monitoring system for monitoring characteristics of power transmitted through one or more power lines. The device comprises a meter base and multiple option modules, where the meter base comprises a processor and associated circuitry for processing signals derived from sensors coupled to said power lines and generates output signals representing selected characteristics of the power transmitted through the power lines. This solution requires a set of cables for each sensor unit connecting to the central unit and is therefore both complicated and space demanding.

Handheld current detection devices are known in the art to be connectable to a central processing computer for collecting and analysing current data. The devices are known to comprise a split core current transformer to easily couple with a conductor by a circuit breaker without breaking the current through the circuit breaker. By the devices a professional is limited to measuring one circuit branch at a time. This is particularly disadvantageous as it is a very time consuming process to measure numerous circuits and difficult to get a synchronised reading from numerous circuit branches for making analysis and comparison.

Therefore there remains a need for an improved and simplified system to measure, collect and transmit synchronised energy data from numerous circuit branches to f. ex a handheld measurement device.

### Summary of the invention

The invention is defined by a circuit branch measurement device according to claim 1 and a system according to claim 8 comprising the device of claim 1.

Object of the present invention is to provide an improved circuit branch measurement system to measure, collect and transmit synchronised energy data from numerous circuit branches to a measurement device to solve the shortcomings of the above mentioned systems and devices. The solution provided in the present invention uses at least one current measurement and data transmitting device electrically and mechanically connected to at least one current sensor module for detecting electrical current by at least one conductor in an electrical distribution panel. A communication driver is integrated in the housing of the current measurement device forming a current measurement and data transmitting device. The invention makes it possible to apply and fit the devices of the invention in conventional electrical panel boards.

The current measurement and data transmitting device provided, is an improved arrangement of utilizing a microprocessor to concurrently obtain and process measurement signals from at least one and up to several mechanically coupled current sensor modules. The present invention provides an improved system to install a circuit branch measurement system of current detection devices into electrical distribution panels for monitoring the condition of separate circuit branches of the distribution panels. The present invention provides a secure and effortless installation arrangement, which saves installation effort and cost by significantly reducing labour in connecting numerous current detectors with conductors of the installation. The present invention furthermore reduces manufacturing cost by utilizing fewer electronic components to achieve the purpose of multi circuit branch measurement and monitoring.

The present invention also provides an improved system of providing identification numbers to detect several current sensor modules in a multi circuit branch installation application for identifying each circuit branch. The circuit branch measurement device of the present invention utilises an external Gateway or other monitoring devices to communicate to a network. The network can be a public or private network that enables the transfer of data and commands, such as a wide area network (WAN) to the internet (world wide web) and/or a local area network (LAN) as a locally hosted intranet.

The circuit branch measurement device of the invention comprises current sensor modules, which are electrically and mechanically connected to the current measurement and data transmitting device. The current measurement and data transmitting device consists of the device housing which houses the printed circuit board, an input/output interface for powering the device by an external power supply, and for transmitting data signals. The current measurement and data transmitting device comprises electrical connectors for electrically linking and mechanically fastening the current sensor modules to the current measurement and data transmitting device. The current sensor modules have connection means for mechanically fastening to the current measurement and data transmitting device via the device's connectors, and by interacting with the device by supplying current measurement signals from the current sensor integrated to the module. The current measurement and data transmitting device processes the measurement signal and can convert an analog signal to a digital signal to be transmitted to an external Gateway/concentrator or a CPU. The module has an opening for passing at least one conductor, which is to be fastened to a circuit breaker through, where the current transformer of the module produces a reduced electrical current in accurate proportion to the current flowing through the conductor. The reduced electrical current from the module is received by the current measurement and data transmitting device as an analog signal and transformed to a digital signal by the device. In an exemplary embodiment of the module the current sensor of the module is a split-core current transformer that is easily coupled around a conductor from a circuit breaker.

The technical advantage of the invention is to us a single current measurement and data transmitting device to securely measure up to several circuit breakers using current sensor modules, which are mechanically and electrically connected to the current measurement and data transmitting device.

In a first aspect of the present invention a circuit branch measurement device is provided. The circuit branch measurement device comprises at least one current measurement and data transmitting device, which further comprises a microprocessor to obtain and process measurement signals, a communication driver to transmit collective data to an external device, an identification microchip for associating identification numbers to current sensors, an input/output interface for external power supply and data transmission, and at least one connector for mechanically connecting to a current sensor. The circuit branch measurement device also comprises at least one current sensor module, which further comprises a current sensor to measure a current by a conductor, and a connector for electrically connecting to an external device for power supply and data transmission. The circuit branch measurement device is characterised in that the current measurement and data transmitting device is mechanically coupled and electrically connected to the at least one current sensor module for detecting a current by at least one circuit branch in an electrical distribution panel. Also, the current measurement and data transmitting device aggregates and consolidates measurements from at least one of the current sensor modules to be transmitted from the system to an external device.

In a second aspect of the present invention a circuit branch measurement system is provided, the system comprising at least one current measurement and data transmitting device, further comprising a microprocessor to obtain and process measurement signals, a communication driver to transmit collective data to an external device, an identification microchip for associating identification numbers to current sensors, an input/output interface for external power supply and data transmission, and at least one connector for mechanically connecting to a current sensor. The circuit branch measurement device also comprises at least one current sensor module, further comprising a current sensor to measure a current by a conductor, and a connector for electrically connecting to an external device for power supply and data transmission. The circuit branch measurement system further comprises at least one circuit branch in an electrical distribution panel, and a monitoring device. The system is characterized in that the current measurement and data transmitting device is mechanically coupled and electrically connected to the at least one current sensor module for detecting a current by at least one circuit branch in an electrical distribution panel. Furthermore, the current measurement and data transmitting device aggregates and consolidates measurements from at least one of the current sensor modules to be transmitted from the system to a monitoring device.

### Description of the Invention.

The following embodiments and definitions all relate to the devices and the system of the invention.

In an embodiment of the present invention the current sensor modules are detachable from the current measurement and data transmitting device.

In an embodiment of the present invention the current sensor is selected from, but not limited to a current transformer, split-core current transformer or a Hall effect sensor. Furthermore, the current sensor module may be operated and powered by the current measurement and data transmitting device.

In an embodiment of the present invention the input/output interface of the current measurement and data transmitting device has a Wi-Fi module.

In an embodiment of the present invention the current sensor module comprises a visual indicator. The visual indicator may be detachable from the current sensor module. Furthermore, the visual indicator comprises at least one LED to indicate a current state, identity process, error status and/or a warning signal of each associated circuit branch.

In an embodiment of the present invention the current sensor module comprises a wireless transmitter powered by the current transformer to transmit data and ID numbers.

In an embodiment of the present invention a Gateway handheld measurement device or other monitoring devices is used to communicate to a local area network and/or a wide area network.

In an embodiment of the present invention data is transmitted by one of a plurality of protocols, such as Modbus, CANopen and EEBus.

In an embodiment of the present invention data is transmitted by wireless means from the current measurement and data transmitting device.

In an embodiment of the present invention the current measurement and data transmitting device collects measurement signals from each attached current sensor module.

In an embodiment of the present invention the number of individual measurements of current sensors are used to identify number of associated circuit branches.

In an embodiment of the present invention at least one current sensor module is associated with a unique identification number to identify a circuit branch.

In an embodiment of the present invention the condition of separate circuit branches of an electrical distribution panel is monitored.

In an embodiment of the present invention the system utilises a Gateway handheld measurement device or other monitoring devices to communicate to a local area network and/or a wide area network.

In an embodiment of the present invention the current sensor module and or indicating LEDs of the current sensor module is an integrated part of a circuit breaker wherein the current measurement and data transmitting device is mechanically and electrically connected to.

The current sensor modules of the invention are detachable from the current measurement and data transmitting device to ensure flexibility of installation. The device may operate as a master device for aggregating or consolidating data from other current measurement and data transmitting devices that serve as slave devices to the master device. The device can also operate as a slave device where the master device is a Gateway, handheld measuring device or other monitoring devices of the alike. The device may communicate by one of a plurality of communication protocols, such as Modbus, M-bus, CANopen and EEbus. Each slave device may be a single message of a determined time interval transmit measurement values of numerous circuit branches to the master device which may also provide several measurement values of circuit branches associated to the master device by other measurement means. As each current measurement and data transmitting device has a single input/output interface and can be interconnected; a situation where numerous of communication conductors of a typical Power system are connected to each current sensor of an installation application in a distribution panel causing the panel to be dense and complicated by large number of conductors is eliminated.

The current sensor module can advantageously be an integral part of a circuit breaker wherein the current measurement and data transmitting device is mechanically and electrically connected to the said circuit breaker. In such an embodiment, the circuit breaker could comprise indicating LEDs to show the state if the circuit breaker.

The current measurement and data transmitting device comprises an identification microchip to associate each attached current sensor module with a unique identification number along with a communication driver to transmit the collective data from the microprocessor by any of a plurality of protocols including wireless configurations to a Gateway, handheld measuring device or other monitoring devices. The device of the invention may include the capability to communicate selectively with one of multiple available protocols, where the device may analyse the received communication and switch between the available protocols according to the analysis. This is particularly advantageous as different available protocols can be used in electrical installations in buildings, thus the system requires no specific setup between various applications.

The circuit branch measurement device of the invention uses solid state relays connected to a resistor for collecting measurement signals from each attached current sensor module by switching measurement readings from one current sensor to the next. The technical advantage is found by the arrangement of the aforementioned electronic components of the current measurement and data transmitting device for collecting measurement value of each circuit branch linked to the system through the current sensor modules, and specifically by the advanced technical ability to collect the number of individual measurements to identify how many circuit branches are linked and active in the distribution panel. The circuit branch measurement device can thus identify and notify if a certain circuit branch of the installation application is disconnected, is overloaded, has no load or tripped.

The current sensor module is plugged into and operated by the current measurement and data transmitting device. The current sensor module comprises a current sensor, which is a current transformer or a split core current transformer, which is electrically linked to the current measurement and data transmitting device of invention through a specific connector which also mechanically links the components together. The current sensor module is operated by the current measurement and data transmitting device and can comprise an indication LED to indicate status connection, identity process, error status and/or warning signal.

In a specific embodiment the current sensor module of invention can be equipped to have a Hall effect sensor to detect a current by a conductor associated to a circuit breaker. The current sensor module would still be characterised as being operated by the current measurement and data transmitting device as the device would power the Hall effect sensor and receive measurements from the Hall effect sensor of the module. The specific objective with using the device to power and receive measurements from the Hall effect sensor of the module is to economise manufacturing cost and save installation time.

In an embodiment of the invention the current sensor module has a visual indicator which allows a user to visually identify the current load status of an associated circuit branch of the system simply by looking at the module attached to a circuit breaker. The indicator may comprise at least one LED to indicate a current status or a plurality of LEDs to indicate current status by magnitude of illumination by each LED and by number of LEDs lighted. The indicator may be a part of an analog circuit inside the current sensor module that is powered by the current transformer of the module. This is particularly advantageous when a current sensor module comprising the indicator is disconnected from the system as the indicator will still be active and self-operated by the current transformer. The indicator is thus characterised as being self-powered by receiving operational power from the current transformer alone and by illuminating each LED by gradually increasing in light and by intensity of light as the current value of the current transformer increases. The indicator may be made visible to a user by having the LEDs visual at a part of the module that sits on the front facet of an associated circuit breaker. In certain embodiments of the invention, wherein the current sensor module does not comprise indication LEDs, the printed circuit board of the current measurement and data transmitting device does not comprise solid state relays.

The part of the indicator which is made visible and comprises the LEDs can be a specific supplementary indicator module which is mechanically connected to the current sensor module and electrically connected to the analog circuit of the current sensor module. The specific indicator module may comprise the analog circuit to operate the LEDs and be a detachable part of the circuit branch measurement device of the invention. Having current indication means which is made accessible on the front facet of an associated circuit breaker is particularly advantageous as the circuit breakers are mostly concealed by an enclosure of the electrical distribution panel board. Therefore, in distribution panel boards, only the front facets of circuit breakers are visible to a user while the current sensor modules are also concealed by the panel enclosure.

In an embodiment of the present invention the current sensor module comprises a Hall effect sensor be an array of LEDs operated by the current measurement and data transmitting device circuit branch measurement device as part of the device's circuitry. In another embodiment of the invention the current sensor module may comprise a wireless transmitter for transmitting information of measurement value and ID number of each module. The wireless transmitter may be a radio frequency identification chip (RFID) having a unique RFID identification number to identify the associated module. The RFID becomes active when the module is not connected to or disconnected from the current measurement and data transmitting device and can therefore be used to associate a specific circuit branch. The RFID message can include data about the module, such as measurements and ID number of associated circuit branch, to be transmitted either to the current measurement and data transmitter device or an external Gateway linked to the current measurement and data transmitting device.

The current transformer of the module may advantageously be used to power the RFID to send an outgoing data message from the module itself. The RFID can also store data of the module to be transmitted and/or retrieved form the module. The specific objective with the RFID is to interconnect a specific circuit branch which is out of range to the current measurement and data transmitting device connected to a number of separate circuit branches. Another specific objective with the RFID is to eliminate the risk of losing data if a specific module is accidentally disconnected from the current measurement and data transmitting device.

The circuit branch measurement device of the present invention is powered by an external 5V up to 30V power supply, such as a linked Gateway or other monitoring devices. It utilises the current measuring and transmitting device to achieve multiple circuit branch measurement readings, and furthermore as the current sensor modules of the invention do not require individual power to operate, the circuit branch measurement device conserves operational energy and is thus advantageously economical in operation to other power systems.

The circuit branch measurement device is arranged to advantageously consolidate load measurements from several circuit branches by the current sensor modules. The advantage is achieved by sending a measurement request from the current measuring and data transmitting device to each current sensor module at a predetermined time interval creating a digital message with a timestamp including all measured circuit branches that is transmitted simultaneously to an external Gateway and/or CPU. With this arrangement, a situation where multiple separate current sensor modules of a power system try to simultaneously communicate multiple measurements to a Gateway, monitoring device or external CPU is eliminated.

Advantageously, the circuit branch measurement device is compact in size as the area surrounding circuit breakers in distribution panels is limited and dense; this provides a speedy installation process and limits further stacking of devices and conductor connections in the distribution panel. In distribution panels the placement of circuit breakers can be by various spacing as auxiliary devices and other accessories can be placed amid circuit breakers inside the panel. The circuit branch measurement device is advantageously flexible as the current sensor module can be plugged into the system by any connector of the current measurement and data transmitting device of the invention creating space for additional auxiliary devices without compromising the setup of the system. In addition, a low-voltage distribution panel already in operation can be retrofitted with the system without any problems; as the circuit branch measurement device can be fitted to various designs of circuit breakers without interfering with the circuit breakers functions.

In a specific embodiment the system may include power management logic and functionality to enable execution instructions, provide operating codes to manage functionality and/or perform logic tasks, perform calculations and control input/output means of the system or controlling devices associated to the system for manipulating circuit branches. In such an embodiment the circuit branch measurement device comprises separate inputs to link with auxiliary switching and controlling devices.

The specific objective with the present invention is to provide a system of electronic measurement devices to improve the installation setup for professionals and to conserve dimensional space inside electrical distribution panels. The objective is reached by making a specific device, a current measurement and data transmitting device, which is used for connecting up to several current sensor modules that form a part of the device and can be easily plugged to the device. The current sensor modules are detachable from the device and are used mainly for detecting electrical current signals to be sent to the device which processes the measurements form the modules and transmits the signals onwards. The device comprises connectors for connecting the current sensor modules to the device. When the current measurement and data transmitting device of the circuit branch measurement device is not connected to current sensor modules by every connector of the device; the remaining connectors of the device can be used to connect to external current transformers or other alternative measurement devices. The device of the system can be adjusted according to installation applications in a distribution panel by break-off method; where in the unused connectors of the device can be broken off. The device may contain markings to indicate where the user can break-off the desired part of the device.

Another specific objective of the invention is to provide a detailed and economical measurement system where the installation process is simple and prompt and provides important information regarding the distribution of electricity through a user's building. By comprising alerting means the circuit branch measurement device can help a user to identify problems and prevent damages and overhead.

The objective is reached by making specific current measurement and data transmitting device which is capable of reading measurements, identifying and operating at least one current sensor module, and up to numerous current sensor modules. The module comprising a current sensor for providing the current measurement and data transmitting device with current measurement signals to process and transmit to an external CPU, handheld measurement device or Gateway.

### Brief description of drawings

**Fig. 1** shows an example of the circuit branch measurement device of the present invention where the current sensor modules are connected to the current measurement and data transmitting device and illustrates how the current sensors are plugged to the device.
**Fig. 2** shows an example of the electronic component arrangement of the current measurement and data transmitting device.
**Fig. 3** illustrates the installation of the system of the invention in a distribution panel comprising circuit breakers and a Gateway where the SYSTEM is connected to circuit breakers.

### Detailed description of drawings

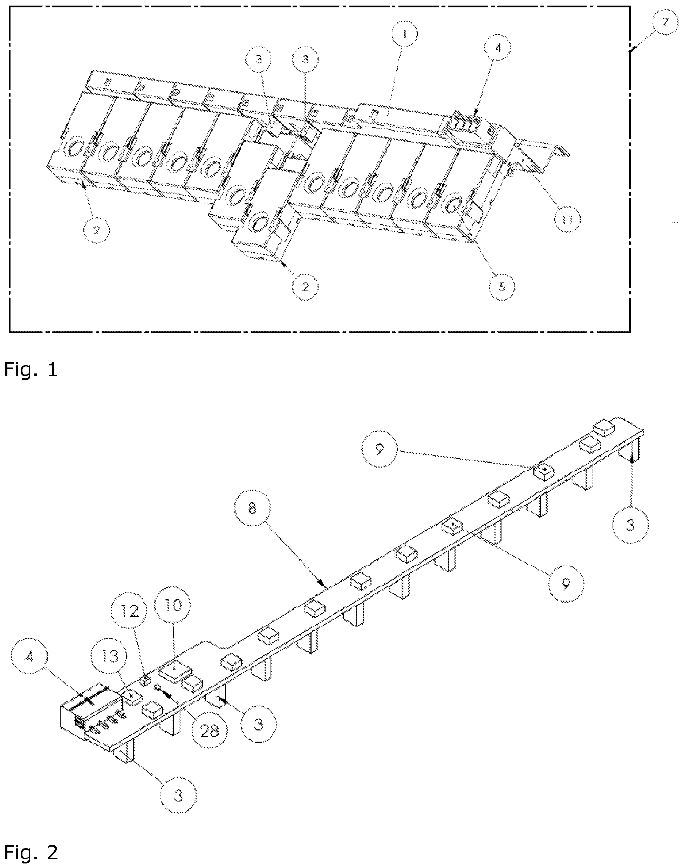

In figure 1 the circuit branch measurement device (7) is illustrated consisting of the current measurement and data transmitting device (1), current sensor modules (2) comprising indication modules (11) mechanically connected to the module (2) and electrically linked to the current sensor of the module (2) and/or the current measurement and data transmitting device (1). The indication module (11) has at least one indication LED for indicating a current status or a link connection with the device (1), for identity process, error status signal and/or warning signal. The indication module (11) is an optional part of the device (7). The current measurement and data transmitting device (1) consists of the device housing which houses the printed circuit board, an input/output interface (4) for powering the device by an external power supply, and for transmitting data signals. The current measurement and data transmitting device (1) can also comprise a LED (not shown) for indicating the link connection with the module (2), for identity process, error status signal and/or warning signal. Furthermore, the module (2) of the invention may comprise a wireless transmitter circuitry for transmitting measurement signals if the module (2) becomes disconnected from the current measurement and data transmitting device (1). The wireless transmitter circuit is powered by the reduced electrical current from the attached conductor and transmitted to a wireless receiver of the device (2). In a specific embodiment of the current measurement and data transmitting device (1) a wireless transmitter is used to transmit digital signals to a Gateway or CPU.

Figure 2 shows a printed circuit board strip (8) located inside the current measurement and data transmitting device (1) is illustrated. It receives measurement signals from the current sensor modules (2) of the circuit branch measurement device (7) and transmist digital signals from the device (1). The PCB strip (8) shown in the embodiment of fig. 2 has solid state relays (9) to collect measurements from the modules (2) by switching between the modules (2) for collecting individual circuit branch measurements. The PCB strip (8) comprises a microprocessor (10) used to collect measurements from at least one module (2) through the connectors (3), which mechanically and electrically connect the current measurement and data transmitting device (1) and the modules (2). The microprocessor (10) transmits a measurement request at a predetermined time interval through each relay (9) for collecting measurement value of each circuit branch. The request includes the number of measurement points to indicate how many circuit branches are connected or active in the installation. The PCB strip (8) comprises an identification chip (12) for providing each module (2) with an ID number which is associated with the circuit branch number of the distribution panel installation. The ID chip (12) can also be integrated in the microprocessor (10).

Each current measurement and data transmitting device (1) is provided with an ID number while each module (2) is provided with a sub-number ID. This is particularly advantageous in large electrical installation applications in buildings where each measurement device provides a single ID number, whereas the system and device of the invention can provide several ID numbers from a single device (1), saving enormous configuration and installation time. The PCB strip (8) furthermore comprises a communication driver (13), for example a RS 485 line driver, to transmit the collective data from the microprocessor via Modbus protocol, or by any of a plurality of protocols including wireless configurations to a Gateway (21), handheld measuring device or monitoring device. The connectors (3) of the PCB strip (8) can be located in various dimensions to associate with an electrical installation application of circuit breakers (15), where the spacing between the connectors (3) will match a half dimension or whole dimension of a circuit breaker (15). This is specifically advantageous where an auxiliary device of less or more than a whole dimension of a circuit breaker (15) is located in between circuit breakers (15). The PCB strip (8) of the invention comprises connection means (4) used as input/output means to power the device (1) and transmit data therefrom. An indication LED (28) can be implemented to the PCB strip (8) for indicating the link connection with the module (2), for identity process, error status signal and/or warning signal.

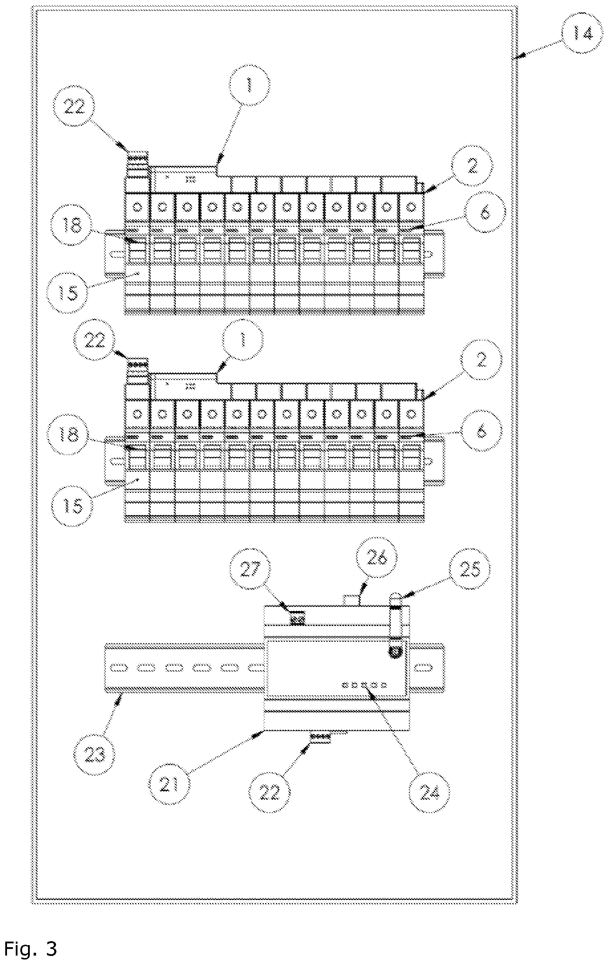

In figure 3 a view of the circuit branch measurement device (7) installed in an electricity distribution panel board (14) and connected to circuit breakers (15) is illustrated. The circuit breakers (15) are placed in line by two separate rows in the panel board (14) where the modules (2) of the circuit branch measurement device (7) are placed on each circuit breaker (15). The modules (2) are connected to the current measurement and data transmitting device (1) of the circuit branch measurement device (7) and comprise LEDs (6) for indicating a current status and/or for displaying a link connection status with the device (1). The current measurement and data transmitting devices (1) of each row in the panel (14) are interconnected by wireless communication or by wirings through the wire connectors (22) connected to the input/output means (4) of the devices (1). The wire connectors (22) are furthermore used to provide operational power to the device (1) from the Gateway/Concentrator (21), which is interconnected to the devices (1) through the connectors (22), and to send and receive data signals to and from the devices (1) and the Gateway (21). The Gateway (21) is attached to a DIN rail (23) in the embodiment shown in Fig. 2 and comprises an antenna (25) for wireless communication to the devices (1) and/or to a modem which transmits the data from the circuit branch measurement device (7) to a local area network or wide area network. The Gateway (21) of the circuit branch measurement device (7) furthermore comprises an Ethernet input/output means (26) and a power supply connection (27) for powering the Gateway (21). The Gateway (21) also comprises a display interface (24) which can be LEDs and/or an LCD for indicating link communication status with the devices (1), connection status with LAN or WAN and current statuses of the circuit branch measurement device (7).

In conventional panel boards (14) a power line is provided to supply power to circuit breakers (15) for distributing and protecting power to electrical applications in a building. The power line is typically connected to a Main breaker (not shown) which can be located in the distribution panel board (14) or in a main panel board (not shown) of a building for protecting the main power to a distribution panel board (14). Typically a distribution bus-bar (not shown) is mechanically connected to the top or bottom side of circuit breakers (15) and used to electrically distribute power to the circuit breakers (15) where each circuit breaker (15) is controlled by a switch (18) for controlling and tripping electrical power to electrical appliances and/or lights connected to each circuit breaker (15). The current measurement and data transmitting device (1) of the circuit branch measurement device (7) is placed and positioned at the output end of the circuit breakers (15) and mechanically connected to the circuit breakers (15) and the current sensor modules (2), where they are electrically coupled to at least one conductor that is fastened and electrically connected to at least one circuit breaker (15). The system (7) measures each circuit breaker (15) as a unique circuit branch to provide detailed information about a current state of each circuit branch and advantageously exploits the small dimensions usually available in a panel board (14) to achieve the measurements.

Furthermore, the technical advantage of the invention is provided by the identification process where the device (1) is configured to be a slave in a communication protocol such as Modbus. The device (1) as a Modbus slave has a unique ID, which is used as a mac address or a serial number in the Modbus protocol. The circuit branch measurement device (7) can advantageously provide ID numbers for several circuit branches (15) by a single slave device (1) to a Gateway (21) or other external CPUs by a communication standard such as RS 485. A unique 6 byte ID number is provided for each device (1) where the last byte is used as the protocol address of the device (1) and advantageously the device's (1) configurative ability to address each electrically connected module (2) with a sub-ID. The sub-ID is added to the unique ID number of the slave device (1) in the message signal of the device (1). The device (1) transmits a single ID message signal through a RS 485 connector (22) containing the multiple sub-ID numbers to identify each associated circuit breaker (15). The message is configured to have a timestamp which relates to the measurement of all associated modules (2) and advantageously provides a single timestamp for several circuit branches (15) simultaneously to a user. This is particularly advantageous to power monitoring systems that process a single ID for a single measurement point and are therefore limited by each communication protocol to a number of ID numbers. The circuit branch measurement device (7) advantageously connects multiple devices (1), each comprising several sub-IDs from the linked modules (2) with an electrical installation in a panel board (14) for transmitting a large amount of circuit branch (15) measurement points to a Gateway (21).

Yet another advantage of the present invention is presented in the Gateway (21), which can communicate the advanced message signals from the circuit branch measurement device (7) to a SCADA system and/or energy monitoring system in an external network, such an a intranet (LAN) or internet (WAN) network. The advantage is provided by the message signal from the system (7) having details of several circuit branches (15) included in a single message signal. The message signal is characterised by containing a unique ID to identify the device (1) where the message furthermore contains sub-IDs associated with the unique ID of the device (1), such as the sub-ID of each module (2).

The device (1) may also be arranged to be shortened to fit a separate three-phase circuit breaker (15) by an installation application. The device (7) may comprise cut-off markings to identify where to break off or saw off the undesired part of the device (1) for fitting an installation application. These markings are not limited to three-phase breakers (15) but can indicate where to shorten the device (1) according to each specific application. Although diverse embodiments of the invention have been described to achieve the advanced functions of the invention, it will be obvious to one skilled in the art that various other embodiments and implementations are possible within the scope of the invention. The invention is solely defined by the appended claims.

## Claims

1. A circuit branch measurement device comprising:
- at least one current measurement and data transmitting device (1), further comprising:
• a microprocessor (10) configured to obtain and process measurement signals,
• a communication driver (13) configured to transmit collective data to an external device,
• an identification microchip (12) for associating identification numbers to current sensors,
• an input/output interface (4) for external power supply and data transmission, and
• at least one connector (3) for connecting to a current sensor
- at least one current sensor module (2) comprising:
• a current sensor to measure a current by a conductor, and
- a further connector (22) connected to the input/output interface (4) for electrically connecting to an external device for power supply and data transmission,
wherein the at least one connector (3) of the current measurement and data transmitting device (1) provides a mechanical fastening and an electrical connection to the at least one current sensor module (2) for detecting a current by at least one circuit branch in an electrical distribution panel, and in that the mechanically coupled and electrically connected at least one current measurement and data transmitting device (1) and the at least one current sensor module (2) fit in a conventional panel board (14), wherein the current measurement and data transmitting device is configured to aggregate and consolidate measurements from at least one of the current sensor modules to be transmitted from the device to an external device.

2. The circuit branch measurement device according to claim 1, wherein the current sensor modules are detachable from the current measurement and data transmitting device.

3. The circuit branch measurement device according to claims 1 or 2, wherein the current sensor is one of a current transformer, split-core current transformer or a Hall effect sensor.

4. The circuit branch measurement device according to any of the preceding claims, wherein the input/output interface of the current measurement and data transmitting device has a Wi-Fi module.

5. The circuit branch measurement device according to any of the preceding claims, wherein the current sensor module comprises a visual indicator.

6. The circuit branch measurement device of claim 5, wherein the visual indicator comprises at least one LED to indicate a current state, identity process, error status and/or a warning signal.

7. The circuit branch measurement device according to claim 3, wherein the current sensor module comprises a wireless transmitter powered by the current transformer to transmit data and ID numbers.

8. A system comprising the circuit branch measurement device of claim 1, the system Z further comprising:
- at least one circuit branch in an electrical distribution panel, and
- a monitoring device,
wherein the current measurement and data transmitting device is configured to aggregate and consolidate measurements from at least one of the current sensor modules to be transmitted from the circuit branch measurement device to the monitoring device.

9. The system according to claim 8, wherein the system is configured to transmit data by one of a plurality of protocols, such as Modbus, CANopen and EEBus.

10. The system according to claims 8 - 9, wherein the current measurement and data transmitting device is configured to collect measurement signals from each attached current sensor module.

11. The system of claim 10, wherein the device is configured to use the number of individual measurements of current sensors to identify number of associated circuit branches.

12. The system of claim 8, wherein the current sensor module is operated and powered by the current measurement and data transmitting device.

13. The system according to claims 8 - 12, wherein at least one current sensor module is associated with a unique identification number to identify a circuit branch.

14. The system according to claims 8 - 13, wherein the system is configured to monitor the condition of separate circuit branches of an electrical distribution panel.

15. The system according to claims 12 - 14, wherein the current sensor module is an integral part of a circuit breaker.

## Patentansprüche

1. Schaltungszweigmesseinrichtung, umfassend:
- mindestens eine Strommess- und Datenübertragungseinrichtung (1), weiter umfassend:
• einen Mikroprozessor (10), der ausgelegt ist zum Erhalten und Verarbeiten von Messsignalen,
• einen Kommunikationstreiber (13), der ausgelegt ist zum Übertragen kollektiver Daten an eine externe Einrichtung,
• einen Identifikationsmikrochip (12) zum Assoziieren von Identifikationszahlen mit Stromsensoren,
• eine Eingangs-/Ausgangs-Schnittstelle (4) für externe Stromversorgung und Datenübertragung, und
• mindestens einen Verbinder (3) zum Verbinden mit einem Stromsensor
- mindestens ein Stromsensormodul (2), umfassend:
• einen Stromsensor zum Messen eines Stroms durch einen Leiter, und
- einen weiteren Verbinder (22), der mit der Eingangs-/Ausgangsschnittstelle (4) verbunden ist zum elektrischen Verbinden mit einer externen Einrichtung für Stromversorgung und Datenübertragung, wobei der mindestens eine Verbinder (3) der Strommess- und Datenübertragungseinrichtung (1) eine mechanische Befestigung und eine elektrische Verbindung zu dem mindestens einen Stromsensormodul (2) bereitstellt zum Detektieren eines Stroms durch mindestens einen Schaltungszweig in einer elektrischen Verteiltafel, und das die mechanisch gekoppelte und elektrisch verbundene mindestens eine Strommess- und Datenübertragungseinrichtung (1) und das mindestens eine Stromsensormodul (2) in eine konventionelle Tafelplatte (14) passen,
wobei die Strommess- und Datenübertragungseinrichtung ausgelegt ist zum Aggregieren und Konsolidieren von Messungen von mindestens einem der Stromsensormodule zur Übertragung von der Einrichtung zu einer externen Einrichtung.

2. Schaltungszweigmesseinrichtung nach Anspruch 1, wobei die Stromsensormodule von der Strommess- und Datenübertragungseinrichtung abnehmbar sind.

3. Schaltungszweigmesseinrichtung nach Ansprüchen 1 oder 2, wobei der Stromsensor einer eines Stromtransformators, eines Zangenstromwandlers oder eines Hall-Effekt-Sensors ist.

4. Schaltungszweigmesseinrichtung nach einem der vorhergehenden Ansprüche, wobei die Eingangs-/Ausgangsschnittstelle der Strommess- und Datenübertragungseinrichtung ein Wi-Fi-Modul aufweist.

5. Schaltungszweigmesseinrichtung nach einem der vorhergehenden Ansprüche, wobei das Stromsensormodul einen Sichtindikator umfasst.

6. Schaltungszweigmesseinrichtung nach Anspruch 5, wobei der Sichtindikator mindestens eine LED zum Anzeigen eines Stromzustands, eines Identitätsprozesses, eines Fehlerstatus und/oder eines Warnsignals umfasst.

7. Schaltungszweigmesseinrichtung nach Anspruch 3,
wobei das Stromsensormodul einen Drahtlosübertrager umfasst, der durch den Stromtransformator bestromt wird, um Daten und ID-Nummern zu übertragen.

8. System, umfassend die Schaltungszweigmesseinrichtung nach Anspruch 1, wobei das System weiter umfasst:
- mindestens einen Schaltungszweig in einer elektrischen Verteiltafel, und
- eine Überwachungseinrichtung,
wobei die Strommess- und Datenübertragungseinrichtung ausgelegt ist zum Aggregieren und Konsolidieren von Messungen von mindestens einem der Stromsensormodule zur Übertragung von der Schaltungszweigmesseinrichtung zu der Überwachungseinrichtung.

9. System nach Anspruch 8, wobei das System ausgelegt ist zum Übertragen von Daten durch eines von mehreren Protokollen, wie etwa Modbus, CANopen und EEBus.

10. System nach Ansprüchen 8-9, wobei die Strommess- und Datenübertragungseinrichtung ausgelegt ist zum Sammeln von Messsignalen von jedem angeschlossenen Stromsensormodul.

11. System nach Anspruch 10, wobei die Einrichtung ausgelegt ist zum Verwenden der Anzahl individueller Messungen von Stromsensoren, um eine Nummer von assoziierten Schaltungszweigen zu identifizieren.

12. System nach Anspruch 8, wobei das Stromsensormodul durch die Strommess- und Datenübertragungseinrichtung betrieben und bestromt wird.

13. System nach Ansprüchen 8-12, wobei mindestens ein Stromsensormodul mit einer eindeutigen Identifikationsnummer assoziiert ist, um einen Schaltungszweig zu identifizieren.

14. System nach Ansprüchen 8-13, wobei das System ausgelegt ist zum Überwachen des Zustands von separaten Schaltungszweigen einer elektrischen Verteiltafel.

15. System nach Ansprüchen 12-14, wobei das Stromsensormodul ein integraler Teil eines Leistungsschalters ist.

## Revendications

1. Dispositif de mesure de branche de circuit comprenant :
- au moins un dispositif (1) de mesure de courant et de transmission de données, comprenant en outre :
• un microprocesseur (10) configuré pour obtenir et traiter des signaux de mesure,
• un pilote de communication (13) configuré pour transmettre des données collectives à un dispositif externe,
• une micropuce d'identification (12) destinée à associer des numéros d'identification à des capteurs de courant,
• une interface entrée/sortie (4) destinée à l'alimentation électrique externe et la transmission de données, et
• au moins un connecteur (3) destiné à se connecter à un capteur de courant
- au moins un module de capteur de courant (2) comprenant :
• un capteur de courant pour mesurer un courant par un conducteur, et
- un connecteur supplémentaire (22) connecté à l'interface entrée/sortie (4) pour se connecter électriquement à un dispositif externe pour l'alimentation électrique et la transmission de données, le ou les connecteurs (3) du dispositif (1) de mesure de courant et de transmission de données fournissant une fixation mécanique et une connexion électrique au ou aux modules de capteur de courant (2) afin de détecter un courant par au moins une branche de circuit dans un panneau de distribution électrique, et en ce que le ou les dispositifs (1) de mesure de courant et de transmission de données et le ou les modules de capteur de courant (2), couplés mécaniquement et connectés électriquement, se logent dans un tableau de panneau conventionnel (14),
le dispositif de mesure de courant et de transmission de données étant configuré pour regrouper et consolider des mesures provenant d'au moins un du ou des modules de capteur de courant pour les transmettre du dispositif à un dispositif externe.

2. Dispositif de mesure de branche de circuit selon la revendication 1, les modules de capteur de courant étant détachables du dispositif de mesure de courant et de transmission de données.

3. Dispositif de mesure de branche de circuit selon les revendications 1 ou 2, le capteur de courant étant l'un parmi un transformateur de courant, un transformateur de courant à pince et un capteur à effet Hall.

4. Dispositif de mesure de branche de circuit selon l'une quelconque des revendications précédentes, l'interface entrée/sortie du dispositif de mesure de courant et de transmission de données possédant un module Wi-Fi.

5. Dispositif de mesure de branche de circuit selon l'une quelconque des revendications précédentes, le module de capteur de courant comprenant un indicateur visuel.

6. Dispositif de mesure de branche de circuit selon la revendication 5, l'indicateur visuel comprenant au moins une LED pour indiquer un état actuel, une méthode d'identification, un statut d'erreur et/ou un signal d'alerte.

7. Dispositif de mesure de branche de circuit selon la revendication 3, le module de capteur de courant comprenant un émetteur sans fil alimenté par le transformateur de courant pour transmettre des données et des numéros d'ID.

8. Système comprenant le dispositif de mesure de branche de circuit selon la revendication 1, le système comprenant en outre :
- au moins une branche de circuit dans un panneau de distribution électrique, et
- un dispositif de surveillance,
le dispositif de mesure de courant et de transmission de données étant configuré pour regrouper et consolider des mesures provenant d'au moins un du ou des modules de capteur de courant pour les transmettre du dispositif de mesure de branche de circuit au dispositif de surveillance.

9. Système selon la revendication 8, le système étant configuré pour transmettre des données par l'un d'une pluralité de protocoles, tels que Modbus, CANopen et EEBus.

10. Système selon les revendications 8 et 9, le dispositif de mesure de courant et de transmission de données étant configuré pour collecter des signaux de mesure auprès de chaque module de capteur de courant rattaché.

11. Système selon la revendication 10, le dispositif étant configuré pour utiliser le nombre de mesures individuelles de capteurs de courant pour identifier le nombre de branches de circuits associées.

12. Système selon la revendication 8, le module de capteur de courant étant exploité et alimenté par le dispositif de mesure de courant et de transmission de données.

13. Système selon les revendications 8 à 12, au moins un module de capteur de courant étant associé à un numéro d'identification unique pour identifier une branche de circuit.

14. Système selon les revendications 8 à 13, le système étant configuré pour surveiller l'état de branches de circuit séparées d'un panneau de distribution électrique.

15. Système selon les revendications 12 à 14, le module de capteur de courant faisant partie intégrante d'un disjoncteur.
